# DEMANDE DE BREVET EUROPEEN

(11) **EP 0 620 704 A1**
(43) Date de publication de la demande: **19.10.1994**
(21) Numéro de dépôt: 94400778.0
(22) Date de dépôt: 11.04.1994
(51) Int. Cl.: H05K 7/14

(54) **Bloc guide-cartes**

(30) Priorité: 16.04.1993 FR 9304524
(71) Demandeur: ALCATEL BUSINESS SYSTEMS, F-75008 Paris (FR)
(72) Inventeur: Ciret, Caroline, F-67600 Selestat (FR); Hugel, Charles, F-67380 Lingolsheim (FR)
(74) Mandataire: Schaub, Bernard

(57) **Abrégé**

Bloc guide-cartes, pour équipement comportant des cartes (2) supports de circuits positionnées en parallèle par l'intermédiaire d'éléments guides (1), à glissières (4) parallèles de maintien de carte, qui sont fixés à une paroi, de type plaque, chaque carte ayant à cet effet au moins un bord maintenu dans une glissière d'un élément guide. Le bloc est constitué d'une pluralité d'éléments guides, qui, parallèles et identiques ou similaires, sont identiquement assujettis l'un à l'autre, de proche en proche, par des entretoises (8) permettant un déplacement relatif entre éléments guides.

## Description

L'invention concerne un bloc guide pour cartes supports de circuits.

Un mode classique de montage des cartes supports de circuits d'un équipement électronique, dans le contenant où elles sont destinées à être logées, implique la mise en place d'éléments guides permettant de monter les cartes perpendiculairement à au moins une des parois ou les éléments guides viennent se positionner.

Dans une forme de réalisation connue, les éléments guides sont dotés de glissières leur permettant de recevoir et maintenir les cartes par un bord, deux éléments guides disposés en regard sur des parois opposées d'un logement permettant alors de maintenir une carte de dimension correspondante appropriée.

Il est avantageux tant pour l'assemblier chargé de réaliser le montage d'un appareil ou d'un équipement d'appareil que pour l'utilisateur que le montage des éléments guides soit simple, stable et sûr et que leur éventuel démontage soit facile.

L'invention propose donc un bloc guide-cartes, pour équipement comportant des cartes supports de circuits positionnées en parallèle par l'intermédiaire d'éléments guides, à glissières parallèles de maintien de carte, qui sont fixés sur une paroi, chaque carte ayant à cet effet au moins un bord maintenu dans une glissière d'un élément guide.

Selon une caractéristique de l'invention, le bloc guide-cartes est constitué d'une pluralité d'éléments guides, qui, parallèles et identiques ou similaires, sont identiquement assujettis l'un à l'autre, de proche en proche, par des entretoises permettant un déplacement relatif entre éléments guides.

Selon une autre caractéristique de l'invention, le bloc guide-cartes comporte des entretoises arquées et flexibles entre éléments guides adjacents

L'invention, ses caractéristiques et ses avantages sont précisés dans la description qui suit en liaison avec les figures évoquées ci-dessous.

La figure 1 présente une vue en perspective une plaque perforée prévue pour permettre la fixation d'éléments guides de montage de cartes.

La figure 2 présente une en vue perspective éclatée d'une partie de bloc guide-cartes, selon l'invention, en association avec une plaque perforée prévue pour son montage.

Les figures 3, 4 présentent des vues de détail d'une extrémité avant d'élément guide d'un bloc selon l'invention.

La figure 5 présente une vue de détail d'un pied d'accrochage pour élément guide d'un bloc, selon l'invention.

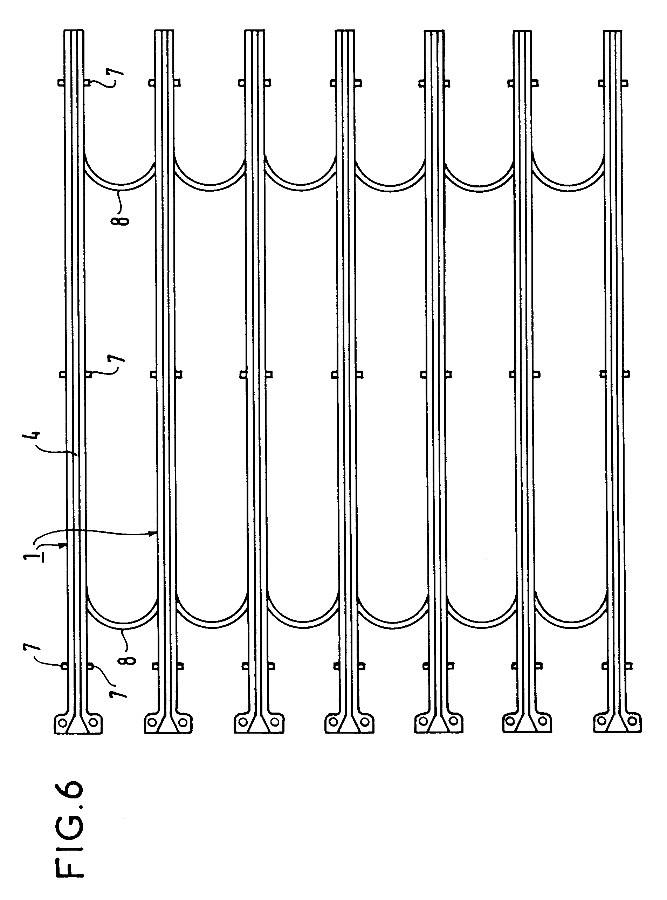

La figure 6 présente une vue de dessus d'un exemple de bloc guide-cartes, selon l'invention.

L'élément guide 1 présenté est destiné à permettre le positionnement d'une carte support de circuits 2 par rapport à une paroi 3 d'un équipement, non représenté, dont cette carte 2 est un élément.

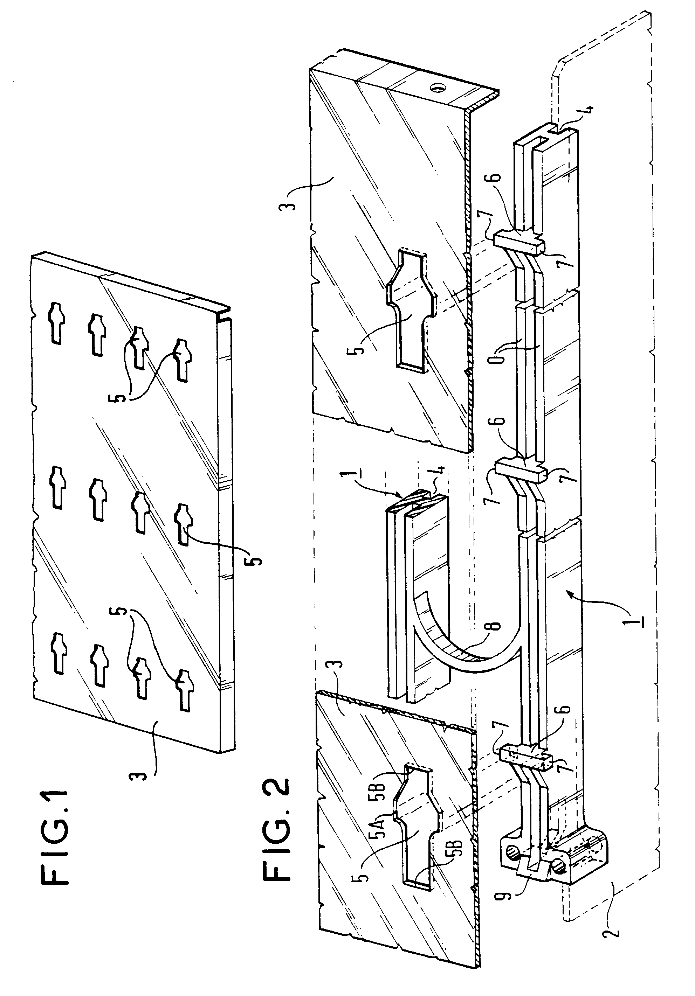

L'équipement est par exemple destiné à être logé dans un contenant, de type bâti, armoire ou tiroir comportant au moins une paroi 3 constituée par une plaque mince perforée de lumières de fixation 5, - voir figure 1 -. Ces lumières sont régulièrement disposées pour permettre l'accrochage d'au moins un élément guide 1 qui comporte une glissière 4 de maintien de carte 2. Dans de nombreux cas, la paroi 3 est destinée à recevoir plusieurs éléments guides 1 permettant un montage parallèle de plusieurs cartes 2.

De même, il est classique de monter des éléments guides 1 face-à-face sur deux parois parallèles pour assurer le positionnement de cartes, par deux des bords opposés de ces cartes, ces dernières étant alors maintenues perpendiculaires aux deux parois entre lesquelles elles se logent.

Les lumières de fixation 5, prévues pour les éléments guides dans une paroi, sont le plus souvent disposées en colonnes parallèles, chaque colonne comportant usuellement au moins deux lumières 5 alignées pour la fixation d'un élément guide doté de pieds d'accrochage 6, appropriés.

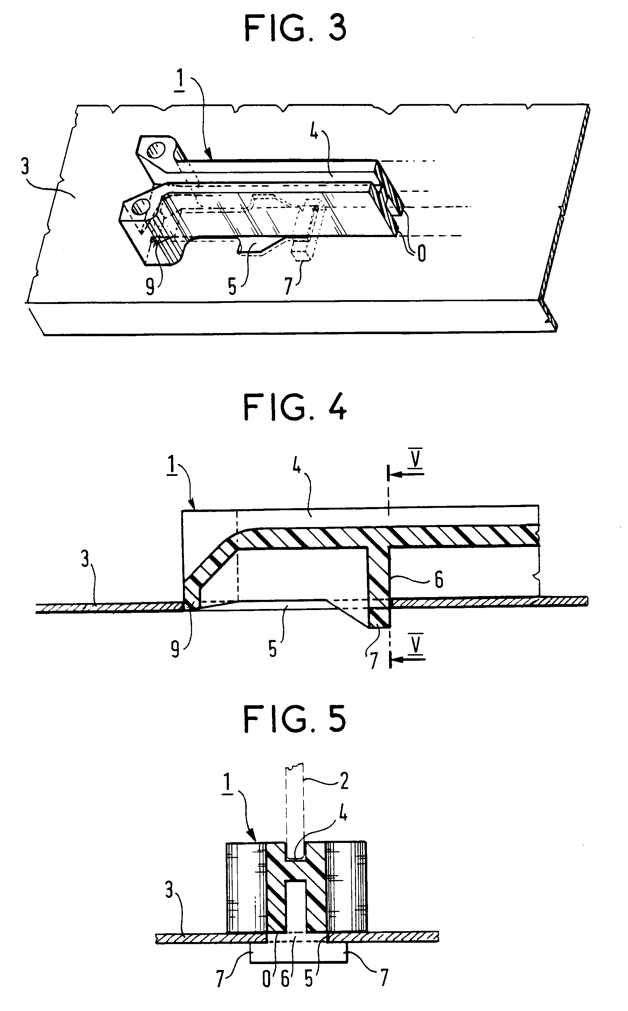

Dans l'exemple présenté en figure 2, l'élément guide 1, d'allure allongée, porte une rainure longitudinale destinée à servir glissière de maintien 4 pour un bord de carte 2 - voir notamment les figures 3 et 5 -, ainsi que des pieds d'accrochage 6, situés sur un côté de l'élément qui est à l'opposé de la rainure formant glissière. Les pieds d'accrochage 6 qui sont alignés, comportent chacun deux prolongements latéraux 7 qui se développent, à un même niveau, de part et d'autre des pieds considérés et qui sont orientées perpendiculairement à l'axe longitudinal de l'élément guide considéré.

Chacun des pieds d'accrochage 6 d'un élément guide 1 est destiné à venir s'introduire dans une lumière de fixation 5 d'une même colonne et à s'y fixer. Dans l'exemple proposé, chaque lumière de fixation 5 comporte une ouverture 5A, dimensionnée pour permettre l'insertion d'un pied d'accrochage, ainsi qu'une fente 5B, plus étroite, s'étendant ici de part et d'autre de l'ouverture 5A, sur des longueurs différentes. Chacun des pieds d'accrochage d'un élément guide est dimensionné de manière que ses prolongements latéraux 7 puissent venir se positionner sous une plaque de paroi 3 en pinçant cette dernière contre une face 0 de l'élément guide considéré d'où saille les pieds d'accrochage, cette face 0 étant ici montrée composée de deux bandes parallèles séparées par une fente. La largeur de la fente 5B est prévue légèrement supérieure à l'épaisseur d'un pied d'accrochage 6 en deçà des prolongements latéraux 7 qu'il porte, de manière à pouvoir retenir un tel pied déplacé selon l'axe de cette fente 5B après avoir été introduit dans l'ouverture 5A associée à elle.

Le dimensionnement et la disposition des lumières de fixation 5 d'une même colonne d'une paroi et des pieds d'accrochage 6 d'un même élément guide 1 sont prévus de manière à permettre une introduction simultanée des pieds d'accrochage de l'élément guide dans les ouvertures des lumières de la colonne où cet élément guide vient se placer et un même positionnement de ces pieds par coulissement dans les fentes 5B où ils sont maintenus par la coopération des prolongements latéraux 7 et de la face 0 de l'élément qui les comporte avec les bords des fentes 5B.

Dans la réalisation présentée et ainsi qu'on le voit sur les figures 4 et 5, il est prévu une disposition pour assurer l'immobilisation de chaque élément guide par rapport à la paroi où il vient se positionner en s'introduisant dans les lumières de fixation d'une colonne.

Selon cette disposition, il est prévu un clip 9 d'immobilisation associé à au moins l'un des pieds d'accrochage 6 de manière à coopérer avec la lumière de fixation où ce pied vient s'insérer. Ce clip est ici montré situé à une extrémité avant d'élément 1 de manière à être aisément accessible, ainsi qu'on le voit sur la figure 4.

Ce clip 9 est disposé pour venir se positionner, dans la lumière où se loge le pied d'accrochage auquel il est associé, en appui antagoniste par rapport à ce pied, dans cette lumière, lorsque celui-ci a été positionné en fond de fente par coulissement. Dans la réalisation proposée, le clip 9 et situé sous la glissière 4 qui s'évase à son niveau et il est constitué sous la forme d'une patte légèrement flexible qui est naturellement recourbée, de manière à pouvoir fléchir sous la pression à la mise en place de l'élément guide qui la comporte et éventuellement lors d'un démontage.

Dans la réalisation envisagée, il est prévu d'associer plusieurs éléments guides 1 en un bloc guide-cartes, ainsi qu'on le voit sur la figure 2. Ce bloc guide-cartes, qui est par exemple réalisé en matériau moulé est composé d'une pluralité d'éléments guides 1 disposés en parallèle avec leurs glissières 4 orientées de manière identique sur une même face du bloc.

Les éléments guides 1 du bloc sont latéralement reliés entre eux par des entretoises 8 qui les positionnent les uns par rapport aux autres. La distance séparant deux éléments guides 1 adjacents d'un bloc est choisie de manière à correspondre à celle séparant deux rangées parallèles adjacentes de lumières de fixation 5 sur le modèle de paroi 3 où il est prévu de fixer ce bloc.

Dans la réalisation proposée, les entretoises 8 sont flexibles en raison de la forme arquée qui leur est donnée et de leur dimensionnement en relation avec la nature du matériau qui les constitue. Ceci permet de dissocier les éléments guides d'un bloc, par rupture des entretoises, ceci permet surtout un certain déplacement d'un élément par rapport à ces voisins de bloc, en profitant de la flexibilité des entretoises, notamment lors du montage du bloc sur une paroi où il vient se fixer. Une compensation simple des tolérances de positionnement des lumières de fixation lors de leur poinçonnage peut également être ainsi obtenue.

La présence des clips 9 des éléments guides permet d'assurer une bonne immobilisation tant de chaque élément que du bloc dont ils sont les parties et autorise par ailleurs un démontage aisé en cas de besoin.

Bien entendu, il est envisageable de constituer des entretoises équivalentes par exemple en modifiant leur forme et leur nombre, de manière à obtenir un résultat identique ou équivalent.

## Revendications

**1/** Bloc guide-cartes, pour équipement comportant des cartes (2 )supports de circuits positionnées en parallèle par l'intermédiaire d'éléments guides (1), à glissières (4) parallèles de maintien de carte, qui sont fixés sur une paroi (3), de type plaque, chaque carte ayant à cet effet au moins un bord maintenu dans une glissière d'un élément guide, caractérisé en ce qu'il est constitué d'une pluralité d'éléments guides, qui, parallèles et identiques ou similaires, sont identiquement assujettis l'un à l'autre, de proche en proche, par des entretoises (8) permettant un déplacement relatif entre éléments guides.

**2/** Bloc guide-cartes, selon la revendication 1, caractérisé en ce qu'il comporte des entretoises (8) arquées et flexibles entre éléments guides (1) adjacents.

**3/** Bloc guide-cartes, selon la revendication 1, destiné à équiper une paroi (3) mince perforée de lumières de fixation (5) parallèles disposées en colonnes correspondant chacune à un élément guide, chaque lumière étant composée d'une ouverture (5A), dimensionnée pour permettre l'insertion d'un pied d'accrochage, ainsi que d'une fente (5B), plus étroite, s'étendant ici de part et d'autre de l'ouverture (5A), caractérisé en ce qu'il est constitué d'une pluralité d'éléments guides (1), de forme allongée, parallèles et identiques ou similaires, qui sont assujettis à proximité de leurs extrémités par des entretoises latérales arquées (8), flexibles pour permettre l'insertion des pieds d'accrochage (6) que chaque élément guide du bloc comporte dans les lumières de fixation correspondantes de la paroi où ces éléments s'assujettissent.

**4/** Bloc guide-cartes, selon la revendication 3, où chaque élément comporte des pieds d'accrochage (6) complémentaires des lumières (5) dans les ouvertures (5A) desquelles ils sont susceptibles d'être introduits et aux fonds des fentes (5B) desquelles ils viennent s'immobiliser par coulissement, caractérisé en ce que chaque élément comporte de plus un clip (9) d'immobilisation, associé à au moins l'un des pieds d'accrochage situé à une extrémité de cet élément, ce clip étant apte à se positionner, dans la lumière où se loge le pied d'accrochage auquel il est associé, en appui antagoniste par rapport à ce pied, dans cette lumière, lorsque celui-ci est positionné en fond de fente.
